(19) Europäisches Patentamt / European Patent Office / Office européen des brevets

(11) **EP 3 896 468 B1**

(12) **EUROPEAN PATENT SPECIFICATION**

(45) Date of publication and mention
of the grant of the patent:
**16.08.2023 Bulletin 2023/33**

(51) International Patent Classification (IPC):
**G01R 31/12** (2020.01)    **G01R 31/00** (2006.01)
**G01R 31/52** (2020.01)    **G01R 31/58** (2020.01)

(21) Application number: **20890914.3**

(52) Cooperative Patent Classification (CPC):
**G01R 31/1272; G01R 31/52; G01R 31/58**

(22) Date of filing: **13.11.2020**

(86) International application number:
**PCT/CN2020/128816**

(87) International publication number:
**WO 2021/098611 (27.05.2021 Gazette 2021/21)**

(54) **PLATFORM FOR TESTING LEAKAGE CURRENT DIFFERENCE FACTOR OF AGED XLPE CABLE, AND METHOD**

PLATTFORM ZUR PRÜFUNG DES LECKSTROMDIFFERENZFAKTORS EINES GEALTERTEN XLPE-KABELS UND VERFAHREN

PLATE-FORME POUR TESTER LE FACTEUR DE DIFFÉRENCE DE COURANT DE FUITE D'UN CÂBLE XLPE ÂGÉ ET PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.11.2019 CN 201911137674**

(43) Date of publication of application:
**20.10.2021 Bulletin 2021/42**

(73) Proprietors:
• **Lincang Power Supply Bureau Yunnan Power Grid Co., Ltd.**
  **Yunnan 677000 (CN)**
• **Electric Power Research Institute, Yunnan Power Grid Co., Ltd.**
  **Yunnan 650217 (CN)**

(72) Inventors:
• **HUANG, Jisheng**
  **Linxiang Zone Lincang, Yunnan 677000 (CN)**
• **FANG, Zhengyun**
  **Linxiang Zone Lincang, Yunnan 677000 (CN)**
• **XIANG, Enxin**
  **Linxiang Zone Lincang, Yunnan 677000 (CN)**
• **ZHAO, Xianping**
  **Linxiang Zone Lincang, Yunnan 677000 (CN)**
• **WANG, Ke**
  **Linxiang Zone Lincang, Yunnan 677000 (CN)**
• **SHEN, Xin**
  **Linxiang Zone Lincang, Yunnan 677000 (CN)**

(74) Representative: **Kolster Oy Ab**
**Salmisaarenaukio 1**
**P.O. Box 204**
**00181 Helsinki (FI)**

(56) References cited:
CN-A- 104 459 486    CN-A- 104 991 168
CN-A- 107 621 595    CN-A- 111 025 096
CN-A- 111 025 097    JP-A- H05 184 028
US-A1- 2012 319 699

• O H N ET AL: "Investigation of high frequency signal propagation characteristics on HV XLPE cables", POWER ENGINEERING CONFERENCE, 2005. IPEC 2005. THE 7TH INTERNATIONAL SINGAPORE 29-02 NOV. 2005, PISCATAWAY, NJ, USA,IEEE, PISCATAWAY, NJ, USA, 29 November 2005 (2005-11-29), pages 1-6, XP010914102, ISBN: 978-981-05-5702-7

**(Cont. next page)**

EP 3 896 468 B1

- **TANG MING ET AL: "A novel technique for on-line location of Partial Discharges on medium voltage cables", 2014 NINTH INTERNATIONAL CONFERENCE ON ECOLOGICAL VEHICLES AND RENEWABLE ENERGIES (EVER), IEEE, 25 March 2014 (2014-03-25), pages 1-6, XP032611908, DOI: 10.1109/EVER.2014.6843993 [retrieved on 2014-06-25]**
- **CATTAREEYA SUWANASI ET AL: "Investigation on partial discharge of power cable termination defects using High Frequency Current Transformer", ELECTRICAL ENGINEERING/ELECTRONICS, COMPUTER, TELECOMMUNICATIONS AND INFORMATION TECHNOLOGY (ECTI-CON), 2013 10TH INTERNATIONAL CONFERENCE ON, IEEE, 15 May 2013 (2013-05-15), pages 1-4, XP032435895, DOI: 10.1109/ECTICON.2013.6559509 ISBN: 978-1-4799-0546-1**

**Description**

**FIELD OF THE INVENTION**

The present invention relates to the field of evaluating an insulating deterioration state of an XLPE cable, and in particular, to a platform and method for measuring a leakage-current difference factor of a deteriorated XLPE cable.

**BACKGROUND OF THE INVENTION**

Cross linked polyethylene (XLPE) is widely used in modern urban distribution networks, and has a lot of advantages, such as high reliability of power supply, good insulation performance, good water resistance and chemical corrosion resistance. However, the XLPE has a disadvantage that cracks are easily generated under mechanical stress. At the same time, due to a complicated operating environment of a cable, the cable may deteriorate as service time goes by. Therefore, to improve reliability of power supply, it is very important to evaluate a deterioration state of the cable.

When in a deterioration state, insulation breakdown may easily occur if the cable is not replaced in time, resulting in a large-scale power outage. As a result, industrial production and life are significantly affected. To reduce a rate of occurrence of XLPE cable failures and improve the reliability of power supply, there is an urgent need for a method that can effectively evaluate insulation performance of the XLPE cable in long-term operation in urban distribution networks. This method is a platform and method for measuring a leakage-current difference factor of a deteriorated XLPE cable. This method is simple to operate and can effectively evaluate the deterioration state of the cable by calculating detected leakage current.

The document "Investigation of high frequency signal propagation characteristics on HV XLPE cables, O H N et. al." discloses a cable testing platform for detecting partial discharges at the dielectric of XLPE cables, and further discloses a method of testing an XLPE cable, the method comprising obtaining current data and calculating a leakage current difference factor, wherein the leakage current difference factor is the ratio of the currents between the two ends of the cable.

SUMMARY OF THE INVENTION

An objective of the present invention is to provide a platform and method for measuring a leakage-current difference factor of a deteriorated XLPE cable, to judge an insulation deterioration state of an XLPE cable in long-term operation of urban distribution networks. This method is simple to operate and can effectively evaluate the deterioration state of the cable by calculating detected leakage current.

Technical solutions of the present invention are set out in the appended set of claims.

It may be learned from the foregoing technical solutions that this application provides a platform and method for measuring a leakage-current difference factor of a deteriorated XLPE cable. According to the present invention, first, the cable leakage current testing platform is first established to test leakage current of an XLPE cable in long-term operation; subsequently, the leakage-current characteristic parameter, the disturbance factor, and the deviation factor of the first high-frequency current transformer are calculated; the leakage-current characteristic parameter, the disturbance factor, and the deviation factor of the second high-frequency current transformer are calculated; and finally, the deterioration state of the XLPE cable is evaluated by means of calculating the leakage-current difference factor, thus improving reliability of power supply of the cable. The present invention is advantageous in that the present invention has advantages of a simple data collection operation, convenient and easy-to-understand field installation and connection steps, and an accurate and reliable calculation process. In this way, the leakage-current difference factor of the deteriorated XLPE cable may be quickly measured, to accurately and effectively evaluate insulation performance of the XLPE cable.

**BRIEF DESCRIPTION OF THE DRAWINGS**

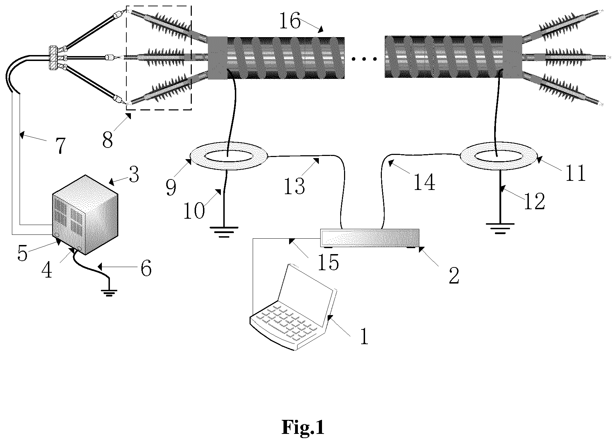

FIG. 1 is a schematic wiring diagram of a cable leakage current testing platform according to the present invention.

**DETAILED DESCRIPTION OF THE EMBODIMENTS**

The present invention is further described below.

According to a wiring diagram of a cable leakage current testing platform in FIG. 1, this application provides a cable leakage current testing platform, including:

a host computer 1, a data collector 2, a high-frequency voltage source 3, a first port 4 of the high-frequency voltage source, a second port 5 of the high-frequency voltage source, a third ground wire 6, a high-voltage test line 7, a terminal 8, a first high-frequency current transformer 9, a first ground wire 10, a second high-frequency current transformer 11, a second ground wire 12, a first signal transmission line 13, a second signal transmission line 14, a third signal transmission line 15, and a test cable 16.

The second port 5 of the high-frequency voltage source is connected to the terminal 8 of the test cable 16 by using the high-voltage test line 7.

The first high-frequency current transformer 9 is sleeved on the first ground wire 10 of the test cable 16.

The second high-frequency current transformer 11 is sleeved on the second ground wire 12 of the test cable 16.

The first high-frequency current transformer 9 is connected to the data collector 2 by using the first signal transmission line 13.

The second high-frequency current transformer 11 is connected to the data collector 2 by using the second signal transmission line 14.

The data collector 2 is connected to the host computer 1 by using the third signal transmission line 15.

The first port 4 of the high-frequency voltage source is grounded by using the third ground wire 6.

This application further provides a method for measuring a leakage-current difference factor of a deteriorated XLPE cable based on the cable leakage current testing platform. The method includes:

obtaining current data based on the cable leakage current testing platform;
calculating a leakage-current difference factor $\lambda$ of the cable based on the current data; and
determining an insulation deterioration state of the cable based on the leakage-current difference factor $\lambda$ of the cable.

Obtaining the current data based on the cable leakage current testing platform specifically includes the following steps:

collecting, by the data collector 2, current data of the test cable 16 by using the first high-frequency current transformer 9 and the second high-frequency current transformer 11, where there are 16 rounds of collection, duration of each round of collection is 5 min, and a time interval of every time of collecting the current data is 2s;
denoting the current data collected by the first high-frequency current transformer 9 by $\alpha_{ij}$, to represent data of $j^{th}$ time collected by the first high-frequency current transformer 9 during $i^{th}$ round of collection; and
denoting the current data collected by the second high-frequency current transformer 11 by $\beta_{ij}$, to represent data of $j^{th}$ time collected by the second high-frequency current transformer 11 during $i^{th}$ round of collection, where both $i$ and $j$ are real numbers, $i \in [1,16]$, and $j \in [1,150]$.

Calculating the leakage-current difference factor $\lambda$ of the cable based on the current data specifically includes the following steps:

calculating a characteristic parameter $\delta_i$ of leakage current of the first high-frequency current transformer 9 based on the current data, where $i \in [1,16]$;

$$\delta_i = \frac{\sum_{j=1}^{150}(\sqrt{\alpha_{ij}^2 + 2.168 \cdot |\alpha_{ij}|}) + \sum_{j=1}^{150}(0.216 \cdot \ln|\alpha_{ij}| + (\alpha_{ij} + 1.026)^2)}{\sum_{j=1}^{150}(2.081\alpha_{ij} + \sqrt{(e^{\alpha_{ij}} + 0.381 \cdot \alpha_{ij})^2 + |\alpha_{ij}|})} \tag{1}$$

calculating a leakage-current characteristic parameter $\mu_i$ of the second high-frequency current transformer 11 based on the current data, where $i \in [1,16]$;

$$\mu_i = \frac{\sum_{j=1}^{150}(\sqrt{\beta_{ij}^2 + 2.168 \cdot |\beta_{ij}|}) + \sum_{j=1}^{150}(0.216 \cdot \ln|\beta_{ij}| + (\beta_{ij} + 1.026)^2)}{\sum_{j=1}^{150}(2.081\beta_{ij} + \sqrt{(e^{\beta_{ij}} + 0.381 \cdot \beta_{ij})^2 + |\beta_{ij}|})} \qquad (2)$$

calculating a leakage-current disturbance factor $K_i$ of the first high-frequency current transformer 9 based on the current data, where $i \in [1,16]$;

$$\overline{\alpha}_i = \frac{1}{150}\sum_{j=1}^{150}\alpha_{ij} \qquad (3)$$

$$\overline{\beta}_i = \frac{1}{150}\sum_{j=1}^{150}\beta_{ij} \qquad (4)$$

$$K_i = \frac{\sum_{j=1}^{150}(\alpha_{ij} - \overline{\alpha}_i) + \sum_{j=1}^{150}(\alpha_{ij} + 0.189e^{\alpha_{ij}})}{\sum_{j=1}^{150}(\alpha_{ij}^2 + 0.162|\alpha_{ij}|)} \qquad (5)$$

calculating a leakage-current disturbance factor $L_i$ of the second high-frequency current transformer 11 based on the current data, where $i \in [1,16]$;

$$L_i = \frac{\sum_{j=1}^{150}(\beta_{ij} - \overline{\beta}_i) + \sum_{j=1}^{150}(\beta_{ij} + 0.189e^{\beta_{ij}})}{\sum_{j=1}^{150}(\beta_{ij}^2 + 0.162|\beta_{ij}|)} \qquad (6)$$

calculating a leakage-current deviation factor $\varepsilon$ of the first high-frequency current transformer 9 based on the current data;

$$\varepsilon = \begin{pmatrix} \delta_1 & \delta_2 & \delta_3 & \delta_4 \\ \delta_5 & \delta_6 & \delta_7 & \delta_8 \\ \delta_9 & \delta_{10} & \delta_{11} & \delta_{12} \\ \delta_{13} & \delta_{14} & \delta_{15} & \delta_{16} \end{pmatrix} \cdot \begin{pmatrix} K_1 & K_2 & K_3 & K_4 \\ K_5 & K_6 & K_7 & K_8 \\ K_9 & K_{10} & K_{11} & K_{12} \\ K_{13} & K_{14} & K_{15} & K_{16} \end{pmatrix} \qquad (7)$$

calculating a leakage-current deviation factor $\eta$ of the second high-frequency current transformer 11 based on the current data;

$$\eta = \begin{pmatrix} \mu_1 & \mu_2 & \mu_3 & \mu_4 \\ \mu_5 & \mu_6 & \mu_7 & \mu_8 \\ \mu_9 & \mu_{10} & \mu_{11} & \mu_{12} \\ \mu_{13} & \mu_{14} & \mu_{15} & \mu_{16} \end{pmatrix} \cdot \begin{pmatrix} L_1 & L_2 & L_3 & L_4 \\ L_5 & L_6 & L_7 & L_8 \\ L_9 & L_{10} & L_{11} & L_{12} \\ L_{13} & L_{14} & L_{15} & L_{16} \end{pmatrix} \quad (8)$$

where ( ) represents a matrix, and • represents matrix point multiplication; and

calculating a leakage-current difference factor $\lambda$ of the cable based on the leakage-current characteristic parameter $\delta_i$, the leakage-current characteristic parameter $\mu_i$, the leakage-current disturbance factor $K_i$, the leakage-current disturbance factor $L_i$, the leakage-current deviation factor $\varepsilon$, and the leakage-current deviation factor $\eta$;

$$\lambda = \frac{1}{\ln 1.359} \frac{0.289 e^{\|\varepsilon\|_2} + 0.801 e^{\|\eta\|_2}}{e^{\|\varepsilon\|_2 + \|\eta\|_2} + \|\varepsilon\|_2 + \|\eta\|_2 + 0.262} \quad (9)$$

where $\|\varepsilon\|_2$ represents a 2-norm of a leakage-current deviation factor matrix $\varepsilon$ of the first high-frequency current transformer 9, and $\|\eta\|_2$ represents a 2-norm of a leakage-current deviation factor matrix $\eta$ of the second high-frequency current transformer 11.

Determining the insulation deterioration state of the cable based on the leakage-current difference factor $\lambda$ of the cable specifically includes the following steps:

if $\lambda < \theta_1$, determining that the insulation deterioration state of the test cable 16 is in a very good state;
if $\theta_1 \le \lambda < \theta_2$, determining that the insulation deterioration state of the test cable 16 is in a good state;
if $\theta_2 \le \lambda < \theta_3$, determining that the insulation deterioration state of the test cable 16 is in a general state; and
if $\lambda \ge \theta_3$, determining that the insulation deterioration state of the test cable 16 is in a damaged state, where $\theta_1 = 0.281$, $\theta_2 = 5.862$, and $\theta_3 = 19.218$.

It may be aware from the foregoing technical solutions that this application provides a platform and method for measuring a leakage-current difference factor of a deteriorated XLPE cable. According to the present invention, first, the cable leakage current testing platform is first established to test leakage current of an XLPE cable in long-term operation; subsequently, the leakage-current characteristic parameter, the disturbance factor, and the deviation factor of the first high-frequency current transformer are calculated; the leakage-current characteristic parameter, the disturbance factor, and the deviation factor of the second high-frequency current transformer are calculated; and finally, the deterioration state of the XLPE cable is evaluated by means of calculating the leakage-current difference factor, thus improving reliability of power supply of the cable. The present invention is advantageous in that the present invention has advantages of a simple data collection operation, convenient and easy-to-understand field installation and connection steps, and an accurate and reliable calculation process. In this way, the leakage-current difference factor of the deteriorated XLPE cable may be quickly measured, to accurately and effectively evaluate insulation performance of the XLPE cable.

**Claims**

1. A method for measuring a leakage-current difference factor of a deteriorated cross linked polyethylene, XPLE, cable, being applied to a cable leakage current testing platform,

   wherein the cable leakage current testing platform, comprising:

   a host computer (1), a data collector (2), a high-frequency voltage source (3), a first port (4) of the high-frequency voltage source, a second port (5) of the high-frequency voltage source, a third ground wire (6), a high-voltage test line (7), a terminal (8), a first high-frequency current transformer (9), a first ground wire (10), a second high-frequency current transformer (11), a second ground wire (12), a first signal transmission line (13), a second signal transmission line (14), a third signal transmission line (15), and a test cable (16), wherein

the second port (5) of the high-frequency voltage source is connected to the terminal (8) of the test cable (16) by using the high-voltage test line (7);
the first high-frequency current transformer (9) is sleeved on the first ground wire (10) of the test cable (16);
the second high-frequency current transformer (11) is sleeved on the second ground wire (12) of the test cable(16);
the first high-frequency current transformer (9) is connected to the data collector (2) by using the first signal transmission line (13);
the second high-frequency current transformer (11) is connected to the data collector (2) by using the second signal transmission line (14);
the data collector (2) is connected to the host computer (1) by using the third signal transmission line (15); and
the first port (4) of the high-frequency voltage source is grounded by using the third ground wire (6);

wherein the method comprises:

obtaining current data based on the cable leakage current testing platform;
calculating a leakage-current difference factor $\lambda$ of the cable based on the current data; and
determining an insulation deterioration state of the cable based on the leakage-current difference factor $\lambda$ of the cable,

**characterized in that** the obtaining current data based on the cable leakage current testing platform specifically comprises the following steps:

collecting, by the data collector (2), current data of the test cable (16) by using the first high-frequency current transformer (9) and the second high-frequency current transformer (11), wherein there are 16 rounds of collection, duration of each round of collection is 5 min, and a time interval of every time of collecting the current data is 2s;
denoting the current data collected by the first high-frequency current transformer (9) by $\alpha_{ij}$, to represent data of $j^{th}$ time collected by the first high-frequency current transformer (9) during $i^{th}$ round of collection; and
denoting the current data collected by the second high-frequency current transformer (11) by $\beta_{ij}$, to represent data of $j^{th}$ time collected by the second high-frequency current transformer (11) during $i^{th}$ round of collection, wherein
both $i$ and $j$ are real numbers, $i \in [1,16]$, and $j \in [1,150]$.

2. The method according to claim 1, wherein the calculating a leakage-current difference factor $\lambda$ of the cable based on the current data specifically comprises the following steps:

calculating a leakage-current characteristic parameter $\delta_i$ of the first high-frequency current transformer (9) based on the current data, wherein $i \in [1,16]$;

$$\delta_i = \frac{\sum_{j=1}^{150}(\sqrt{\alpha_{ij}^2 + 2.168\cdot|\alpha_{ij}|}) + \sum_{j=1}^{150}(0.216\cdot\ln|\alpha_{ij}| + (\alpha_{ij} + 1.026)^2)}{\sum_{j=1}^{150}(2.081\alpha_{ij} + \sqrt{(e^{\alpha_{ij}} + 0.381\cdot\alpha_{ij})^2 + |\alpha_{ij}|})} \quad (1)$$

calculating a leakage-current characteristic parameter $\mu_i$ of the second high-frequency current transformer (11) based on the current data, wherein $i \in [1,16]$;

$$\mu_i = \frac{\sum_{j=1}^{150}(\sqrt{\beta_{ij}^2 + 2.168\cdot|\beta_{ij}|}) + \sum_{j=1}^{150}(0.216\cdot\ln|\beta_{ij}| + (\beta_{ij} + 1.026)^2)}{\sum_{j=1}^{150}(2.081\beta_{ij} + \sqrt{(e^{\beta_{ij}} + 0.381\cdot\beta_{ij})^2 + |\beta_{ij}|})} \quad (2)$$

calculating a leakage-current disturbance factor $K_i$ of the first high-frequency current transformer (9) based on the current data, wherein $i \in [1,16]$;

$$\overline{\alpha}_i = \frac{1}{150}\sum_{j=1}^{150}\alpha_{ij} \qquad (3)$$

$$\overline{\beta}_i = \frac{1}{150}\sum_{j=1}^{150}\beta_{ij} \qquad (4)$$

$$K_i = \frac{\sum_{j=1}^{150}(\alpha_{ij} - \overline{\alpha}_i) + \sum_{j=1}^{150}(\alpha_{ij} + 0.189e^{\alpha_{ij}})}{\sum_{j=1}^{150}(\alpha_{ij}^2 + 0.162\,|\,\alpha_{ij}\,|)} \qquad (5)$$

calculating a leakage-current disturbance factor $L_i$ of the second high-frequency current transformer (11) based on the current data, wherein $i \in [1,16]$;

$$L_i = \frac{\sum_{j=1}^{150}(\beta_{ij} - \overline{\beta}_i) + \sum_{j=1}^{150}(\beta_{ij} + 0.189e^{\beta_{ij}})}{\sum_{j=1}^{150}(\beta_{ij}^2 + 0.162\,|\,\beta_{ij}\,|)} \qquad (6)$$

calculating a leakage-current deviation factor $\varepsilon$ of the first high-frequency current transformer (9) based on the current data;

$$\varepsilon = \begin{pmatrix} \delta_1 & \delta_2 & \delta_3 & \delta_4 \\ \delta_5 & \delta_6 & \delta_7 & \delta_8 \\ \delta_9 & \delta_{10} & \delta_{11} & \delta_{12} \\ \delta_{13} & \delta_{14} & \delta_{15} & \delta_{16} \end{pmatrix} \cdot \begin{pmatrix} K_1 & K_2 & K_3 & K_4 \\ K_5 & K_6 & K_7 & K_8 \\ K_9 & K_{10} & K_{11} & K_{12} \\ K_{13} & K_{14} & K_{15} & K_{16} \end{pmatrix} \qquad (7)$$

calculating a leakage-current deviation factor $\eta$ of the second high-frequency current transformer (11) based on the current data;

$$\eta = \begin{pmatrix} \mu_1 & \mu_2 & \mu_3 & \mu_4 \\ \mu_5 & \mu_6 & \mu_7 & \mu_8 \\ \mu_9 & \mu_{10} & \mu_{11} & \mu_{12} \\ \mu_{13} & \mu_{14} & \mu_{15} & \mu_{16} \end{pmatrix} \cdot \begin{pmatrix} L_1 & L_2 & L_3 & L_4 \\ L_5 & L_6 & L_7 & L_8 \\ L_9 & L_{10} & L_{11} & L_{12} \\ L_{13} & L_{14} & L_{15} & L_{16} \end{pmatrix} \qquad (8)$$

wherein ( ) represents a matrix, and • represents matrix point multiplication; and

calculating a leakage-current difference factor $\lambda$ of the cable based on the leakage-current characteristic parameter $\delta_i$, the leakage-current characteristic parameter $\mu_i$, the leakage-current disturbance factor $K_i$, the leakage-current disturbance factor $L_i$, the leakage-current deviation factor $\varepsilon$, and the leakage-current deviation

factor $\eta$;

$$\lambda = \frac{1}{\ln 1.359} \frac{0.289e^{\|\varepsilon\|_2} + 0.801e^{\|\eta\|_2}}{e^{\|\varepsilon\|_2 + \|\eta\|_2} + \|\varepsilon\|_2 + \|\eta\|_2 + 0.262} \quad (9)$$

wherein $\|\varepsilon\|_2$ represents a 2-norm of a leakage-current deviation factor matrix $\varepsilon$ of the first high-frequency current transformer (9), and $\|\eta\|_2$ represents a 2-norm of a leakage-current deviation factor matrix $\eta$ of the second high-frequency current transformer (11).

3. The method according to claim 1, wherein the determining an insulation deterioration state of the cable based on the leakage-current difference factor $\lambda$ of the cable specifically comprises the following steps:

if $\lambda < \theta_1$, determining that the insulation deterioration state of the test cable (16) is in a very good state;
if $\theta_1 \leq \lambda < \theta_2$, determining that the insulation deterioration state of the test cable (16) is in a good state;
if $\theta_2 \leq \lambda < \theta_3$, determining that the insulation deterioration state of the test cable (16) is in a general state; and
if $\lambda \geq \theta_3$, determining that the insulation deterioration state of the test cable (16) is in a damaged state, wherein $\theta_1 = 0.281$, $\theta_2 = 5.862$, and $\theta_3 = 19.218$.

**Patentansprüche**

1. Verfahren zur Messung eines Leckstrom-Differenzfaktors eines beschädigten Kabels aus vernetztem Polyethylen,XPLE, das auf einer Kabelleckstrom-Testplattform angewendet wird,
wobei die Kabelleckstrom-Testplattform Folgendes umfasst:

einen Host-Computer (1), einen Datensammler (2), eine Hochfrequenz-Spannungsquelle (3), einen ersten Anschluss (4) der Hochfrequenz-Spannungsquelle, einen zweiten Anschluss (5) der Hochfrequenz-Spannungsquelle, einen dritten Erdleiter (6), eine Hochspannungs-Testleitung (7), eine Anschlussklemme (8), einen ersten Hochfrequenz-Stromwandler (9), einen ersten Erdleiter (10), einen zweiten Hochfrequenz-Stromwandler (11), einen zweiten Erdleiter (12), eine erste Signalübertragungsleitung (13), eine zweite Signalübertragungsleitung (14), eine dritte Signalübertragungsleitung (15) und ein Testkabel (16), wobei
der zweite Anschluss (5) der Hochfrequenz-Spannungsquelle über die Hochspannungs-Testleitung (7) mit der Anschlussklemme (8) des Testkabels (16) verbunden ist;
der erste Hochfrequenz-Stromwandler (9) auf den ersten Erdleiter (10) des Testkabels (16) geschoben ist;
der zweite Hochfrequenz-Stromwandler (11) auf den zweiten Erdleiter (12) des Testkabels (16) geschoben ist;
der erste Hochfrequenz-Stromwandler (9) über die erste Signalübertragungsleitung (13) mit dem Datensammler (2) verbunden ist;
der zweite Hochfrequenz-Stromwandler (11) über die zweite Signalübertragungsleitung (14) mit dem Datensammler (2) verbunden ist;
der Datensammler (2) über die dritte Signalübertragungsleitung (15) mit dem Host-Computer (1) verbunden ist; und
der erste Anschluss (4) der Hochfrequenz-Spannungsquelle über den dritten Erdleiter (6) geerdet ist;
wobei das Verfahren umfasst:

Gewinnen von Stromdaten basierend auf der Kabelleckstrom-Testplattform;
Berechnen eines Leckstrom-Differenzfaktors $\lambda$ des Kabels basierend auf den Stromdaten; und
Bestimmen eines Isolationsverschlechterungszustands des Kabels basierend auf dem Leckstrom-Differenzfaktor $\lambda$ des Kabels,
**dadurch gekennzeichnet, dass** das Gewinnen von Stromdaten basierend auf Kabelleckstrom-Testplattform insbesondere die folgenden Schritte umfasst:

Sammeln, durch den Datensammler (2), von Stromdaten des Testkabels (16) unter Verwendung des ersten Hochfrequenz-Stromwandlers (9) und des zweiten Hochfrequenz-Stromwandlers (11), wobei es 16 Sammelrunden gibt, die Dauer jeder Sammelrunde 5 Minuten beträgt und ein Zeitintervall für jeden Zeitpunkt des Sammelns der Stromdaten 2 s beträgt;
Bezeichnen der von dem ersten Hochfrequenz-Stromwandler (9) gesammelten Stromdaten mit $\alpha_{ij}$, um

die Daten des j-ten Zeitpunkts darzustellen, die von dem ersten Hochfrequenz-Stromwandler (9) während der i-ten Sammelrunde gesammelt wurden; und

Bezeichnen der von dem zweiten Hochfrequenz-Stromwandler (11) gesammelten Stromdaten mit $\beta_{ij}$, um die Daten des j-ten Zeitpunkts darzustellen, die von dem zweiten Hochfrequenz-Stromwandler (11) während der i-ten Sammelrunde gesammelt wurden, wobei

sowohl $i$ als auch $j$ reelle Zahlen sind, $i \in [1, 16]$ und $j \in [1,150]$.

2. Verfahren nach Anspruch 1, wobei das Berechnen eines Leckstrom-Differenzfaktors $\lambda$ des Kabels basierend auf den Stromdaten insbesondere die folgenden Schritte umfasst:

Berechnen eines Leckstrom-Kennwertes $\delta_i$ des ersten Hochfrequenz-Stromwandlers (9) basierend auf den Stromdaten, wobei $i \in [1, 16]$;

$$\delta_i = \frac{\sum_{j=1}^{150}(\sqrt{\alpha_{ij}^2 + 2.168 \cdot |\alpha_{ij}|}) + \sum_{j=1}^{150}(0.216 \cdot \ln|\alpha_{ij}| + (\alpha_{ij} + 1.026)^2)}{\sum_{j=1}^{150}(2.081\alpha_{ij} + \sqrt{(e^{\alpha_{ij}} + 0.381 \cdot \alpha_{ij})^2 + |\alpha_{ij}|})} \qquad (1)$$

Berechnen eines Leckstrom-Kennwertes $\mu_i$ der zweiten Hochfrequenz-Stromwandlers (11) basierend auf den Stromdaten, wobei $i \in [1, 16]$;

$$\mu_i = \frac{\sum_{j=1}^{150}(\sqrt{\beta_{ij}^2 + 2.168 \cdot |\beta_{ij}|}) + \sum_{j=1}^{150}(0.216 \cdot \ln|\beta_{ij}| + (\beta_{ij} + 1.026)^2)}{\sum_{j=1}^{150}(2.081\beta_{ij} + \sqrt{(e^{\beta_{ij}} + 0.381 \cdot \beta_{ij})^2 + |\beta_{ij}|})} \qquad (2)$$

Berechnen eines Leckstrom-Störfaktors $K_i$ des ersten Hochfrequenz-Stromwandlers (9) basierend auf den Stromdaten, wobei $i \in [1, 16]$;

$$\overline{\alpha}_i = \frac{1}{150}\sum_{j=1}^{150}\alpha_{ij} \qquad (3)$$

$$\overline{\beta}_i = \frac{1}{150}\sum_{j=1}^{150}\beta_{ij} \qquad (4)$$

$$K_i = \frac{\sum_{j=1}^{150}(\alpha_{ij} - \overline{\alpha}_i) + \sum_{j=1}^{150}(\alpha_{ij} + 0.189e^{\alpha_{ij}})}{\sum_{j=1}^{150}(\alpha_{ij}^2 + 0.162|\alpha_{ij}|)} \qquad (5)$$

Berechnen eines Leckstrom-Störfaktors $L_i$ des zweiten Hochfrequenz-Stromwandlers (11) basierend auf den Stromdaten, wobei $i \in [1, 16]$;

$$L_i = \frac{\sum_{j=1}^{150}(\beta_{ij} - \overline{\beta}_i) + \sum_{j=1}^{150}(\beta_{ij} + 0.189e^{\beta_{ij}})}{\sum_{j=1}^{150}(\beta_{ij}^2 + 0.162\,|\beta_{ij}|)} \qquad (6)$$

Berechnen eines Leckstrom-Abweichungsfaktors $\varepsilon$ des ersten Hochfrequenz-Stromwandlers (9) basierend auf den Stromdaten;

$$\varepsilon = \begin{pmatrix} \delta_1 & \delta_2 & \delta_3 & \delta_4 \\ \delta_5 & \delta_6 & \delta_7 & \delta_8 \\ \delta_9 & \delta_{10} & \delta_{11} & \delta_{12} \\ \delta_{13} & \delta_{14} & \delta_{15} & \delta_{16} \end{pmatrix} \cdot \begin{pmatrix} K_1 & K_2 & K_3 & K_4 \\ K_5 & K_6 & K_7 & K_8 \\ K_9 & K_{10} & K_{11} & K_{12} \\ K_{13} & K_{14} & K_{15} & K_{16} \end{pmatrix} \qquad (7)$$

Berechnen eines Leckstrom-Abweichungsfaktors $\eta$ des zweiten Hochfrequenz-Stromwandlers (11) basierend auf den Stromdaten;

$$\eta = \begin{pmatrix} \mu_1 & \mu_2 & \mu_3 & \mu_4 \\ \mu_5 & \mu_6 & \mu_7 & \mu_8 \\ \mu_9 & \mu_{10} & \mu_{11} & \mu_{12} \\ \mu_{13} & \mu_{14} & \mu_{15} & \mu_{16} \end{pmatrix} \cdot \begin{pmatrix} L_1 & L_2 & L_3 & L_4 \\ L_5 & L_6 & L_7 & L_8 \\ L_9 & L_{10} & L_{11} & L_{12} \\ L_{13} & L_{14} & L_{15} & L_{16} \end{pmatrix} \qquad (8)$$

wobei ( ) eine Matrix darstellt, und • eine Matrixpunktmultiplikation darstellt; und
Berechnen eines Leckstromdifferenzfaktors $\lambda$ des Kabels basierend auf dem Leckstrom-Kennwert $\delta_i$, dem Leckstrom-Kennwert $\mu_i$, des Leckstrom-Störfaktors $K_i$, dem Leckstrom-Störfaktor $L_i$, dem Leckstrom-Abweichungsfaktor $\varepsilon$ und dem Leckstrom-Abweichungsfaktor $\eta$;

$$\lambda = \frac{1}{\ln 1.359} \frac{0.289e^{\|\varepsilon\|_2} + 0.801e^{\|\eta\|_2}}{e^{\|\varepsilon\|_2 + \|\eta\|_2} + \|\varepsilon\|_2 + \|\eta\|_2 + 0.262} \qquad (9)$$

wobei $\|\varepsilon\|_2$ eine 2-Norm einer Leckstrom-Abweichungsfaktor-Matrix $\varepsilon$ des ersten Hochfrequenz-Stromwandlers (9) darstellt, und $\|\eta\|_2$ eine 2-Norm einer Leckstrom-Abweichungsfaktor-Matrix $\eta$ des zweiten Hochfrequenz-Stromwandlers (11) darstellt.

3. Verfahren nach Anspruch 1, wobei das Bestimmen eines Isolationsverschlechterungszustandes des Kabels basierend auf dem Leckstrom-Differenzfaktor $\lambda$ des Kabels insbesondere die folgenden Schritte umfasst:

wenn $\lambda < \theta_1$, Bestimmen, dass der Isolationsverschlechterungszustand des Testkabels (16) in einem sehr guten Zustand ist;
wenn $\theta_1 \leq A < \theta_2$, Bestimmen, dass der Isolationsverschlechterungszustand des Testkabels (16) in guten Zustand ist;
wenn $\theta_2 \leq \lambda < \theta_3$, Bestimmen, dass der Isolationsverschlechterungszustand des Testkabels (16) in einem allgemeinen Zustand ist; und
wenn $\lambda \geq \theta_3$, Bestimmen, dass der Isolationsverschlechterungszustand des Testkabels (16) in einem beschädigten Zustand ist, wobei
$\theta_1 = 0{,}281$, $\theta_2 = 5{,}862$ und $\theta_3 = 19{,}218$.

**Revendications**

1. Procédé pour la mesure d'un facteur de différence de courant de fuite d'un câble en polyéthylène réticulé, XPLE, détérioré, qui est appliqué à une plate-forme de test de courant de fuite de câble, dans lequel la plate-forme de test de courant de fuite de câble comprenant :

   un ordinateur hôte (1), un collecteur de données (2), une source de tension à haute fréquence (3), un premier port (4) de la source de tension à haute fréquence, un second port (5) de la source de tension à haute fréquence, un troisième fil de masse (6), une ligne de test à haute tension (7), une borne (8), un premier transformateur de courant à haute fréquence (9), un premier fil de masse (10), un second transformateur de courant à haute fréquence (11), un deuxième fil de masse (12), une première ligne de transmission de signal (13), une deuxième ligne de transmission de signal (14), une troisième ligne de transmission de signal (15), et un câble de test (16), dans lequel
   le second port (5) de la source de tension à haute fréquence est connecté à la borne (8) du câble de test (16) en utilisant la ligne de test à haute tension (7) ;
   le premier transformateur de courant à haute fréquence (9) est emmanché sur le premier fil de masse (10) du câble de test (16) ;
   le second transformateur de courant à haute fréquence (11) est emmanché sur le deuxième fil de masse (12) du câble de test (16) ;
   le premier transformateur de courant à haute fréquence (9) est connecté au collecteur de données (2) en utilisant la première ligne de transmission de signal (13) ;
   le second transformateur de courant à haute fréquence (11) est connecté au collecteur de données (2) en utilisant la deuxième ligne de transmission de signal (14) ;
   le collecteur de données (2) est connecté à l'ordinateur hôte (1) en utilisant la troisième ligne de transmission de signal (15) ; et
   le premier port (4) de la source de tension à haute fréquence est mis à la masse en utilisant le troisième fil de masse (6) ;
   dans lequel le procédé comprend :

   l'obtention de données de courant sur la base de la plate-forme de test de courant de fuite de câble ;
   le calcul d'un facteur de différence de courant de fuite $\lambda$ du câble sur la base des données de courant ; et
   la détermination d'un état de détérioration d'isolation du câble sur la base du facteur de différence de courant de fuite $\lambda$ du câble,
   **caractérisé en ce que** l'obtention de données de courant sur la base de la plate-forme de test de courant de fuite de câble comprend spécifiquement les étapes suivantes :

   la collecte, par le collecteur de données (2), de données de courant du câble de test (16) en utilisant le premier transformateur de courant à haute fréquence (9) et le second transformateur de courant à haute fréquence (11), dans lequel il y a 16 séries de collecte, la durée de chaque série de collecte est de 5 min, et un intervalle de temps de chaque occurrence de collecte des données de courant est de 2 s ;
   la désignation des données de courant collectées par le premier transformateur de courant à haute fréquence (9) par $\alpha_{ij}$, pour représenter des données de $j^{ème}$ occurrence collectées par le premier transformateur de courant à haute fréquence (9) pendant la $i^{ème}$ série de collecte ; et
   la désignation des données de courant collectées par le second transformateur de courant à haute fréquence (11) par $\beta_{ij}$, pour représenter des données de $j^{ème}$ occurrence collectées par le second transformateur de courant à haute fréquence (11) pendant la $i^{ème}$ série de collecte, dans lequel
   à la fois i et j sont des nombres réels, i E [1, 16], et j E [1, 150].

2. Procédé selon la revendication 1, dans lequel le calcul d'un facteur de différence de courant de fuite $\lambda$ du câble sur la base des données de courant comprend spécifiquement les étapes suivantes :

   le calcul d'un paramètre caractéristique de courant de fuite $\delta_i$ du premier transformateur de courant à haute fréquence (9) sur la base des données de courant, dans lequel i E [1, 16] ;

$$\delta_i = \frac{\sum_{j=1}^{150}(\sqrt{\alpha_{ij}^2 + 2.168\cdot|\alpha_{ij}|}) + \sum_{j=1}^{150}(0.216\cdot\ln|\alpha_{ij}| + (\alpha_{ij} + 1.026)^2)}{\sum_{j=1}^{150}(2.081\alpha_{ij} + \sqrt{(e^{\alpha_{ij}} + 0.381\cdot\alpha_{ij})^2 + |\alpha_{ij}|})}$$

$$(1)$$

le calcul d'un paramètre caractéristique de courant de fuite $\mu_i$ du second transformateur de courant à haute fréquence (11) sur la base des données de courant, dans lequel i E [1, 16] ;

$$\mu_i = \frac{\sum_{j=1}^{150}(\sqrt{\beta_{ij}^2 + 2.168\cdot|\beta_{ij}|}) + \sum_{j=1}^{150}(0.216\cdot\ln|\beta_{ij}| + (\beta_{ij} + 1.026)^2)}{\sum_{j=1}^{150}(2.081\beta_{ij} + \sqrt{(e^{\beta_{ij}} + 0.381\cdot\beta_{ij})^2 + |\beta_{ij}|})}$$

$$(2)$$

le calcul d'un facteur de perturbation de courant de fuite $K_i$ du premier transformateur de courant à haute fréquence (9) sur la base des données de courant, dans lequel i E [1, 16] ;

$$\overline{\alpha}_i = \frac{1}{150}\sum_{j=1}^{150}\alpha_{ij}$$

$$(3)$$

$$\overline{\beta}_i = \frac{1}{150}\sum_{j=1}^{150}\beta_{ij}$$

$$(4)$$

$$K_i = \frac{\sum_{j=1}^{150}(\alpha_{ij} - \overline{\alpha}_i) + \sum_{j=1}^{150}(\alpha_{ij} + 0.189e^{\alpha_{ij}})}{\sum_{j=1}^{150}(\alpha_{ij}^2 + 0.162|\alpha_{ij}|)}$$

$$(5)$$

le calcul d'un facteur de perturbation de courant de fuite $L_i$ du second transformateur de courant à haute fréquence (11) sur la base des données de courant, dans lequel i E [1, 16] ;

$$L_i = \frac{\sum_{j=1}^{150}(\beta_{ij} - \overline{\beta}_i) + \sum_{j=1}^{150}(\beta_{ij} + 0.189e^{\beta_{ij}})}{\sum_{j=1}^{150}(\beta_{ij}^2 + 0.162|\beta_{ij}|)}$$

$$(6)$$

le calcul d'un facteur d'écart de courant de fuite $\varepsilon$ du premier transformateur de courant à haute fréquence (9) sur la base des données de courant ;

$$\varepsilon = \begin{pmatrix} \delta_1 & \delta_2 & \delta_3 & \delta_4 \\ \delta_5 & \delta_6 & \delta_7 & \delta_8 \\ \delta_9 & \delta_{10} & \delta_{11} & \delta_{12} \\ \delta_{13} & \delta_{14} & \delta_{15} & \delta_{16} \end{pmatrix} \cdot \begin{pmatrix} K_1 & K_2 & K_3 & K_4 \\ K_5 & K_6 & K_7 & K_8 \\ K_9 & K_{10} & K_{11} & K_{12} \\ K_{13} & K_{14} & K_{15} & K_{16} \end{pmatrix} \quad (7)$$

le calcul d'un facteur d'écart de courant de fuite $\eta$ du second transformateur de courant à haute fréquence (11) sur la base des données de courant ;

$$\eta = \begin{pmatrix} \mu_1 & \mu_2 & \mu_3 & \mu_4 \\ \mu_5 & \mu_6 & \mu_7 & \mu_8 \\ \mu_9 & \mu_{10} & \mu_{11} & \mu_{12} \\ \mu_{13} & \mu_{14} & \mu_{15} & \mu_{16} \end{pmatrix} \cdot \begin{pmatrix} L_1 & L_2 & L_3 & L_4 \\ L_5 & L_6 & L_7 & L_8 \\ L_9 & L_{10} & L_{11} & L_{12} \\ L_{13} & L_{14} & L_{15} & L_{16} \end{pmatrix} \quad (8)$$

dans lequel ( ) représente une matrice, et • représente une multiplication ponctuelle de matrice ; et le calcul d'un facteur de différence de courant de fuite $\lambda$ du câble sur la base du paramètre caractéristique de courant de fuite $\delta_i$, du paramètre caractéristique de courant de fuite $\mu_i$, du facteur de perturbation de courant de fuite $K_i$, du facteur de perturbation de courant de fuite $L_i$, du facteur d'écart de courant de fuite $\varepsilon$, et du facteur d'écart de courant de fuite $\eta$ ;

$$\lambda = \frac{1}{\ln 1.359} \frac{0.289 e^{\|\varepsilon\|_2} + 0.801 e^{\|\eta\|_2}}{e^{\|\varepsilon\|_2 + \|\eta\|_2} + \|\varepsilon\|_2 + \|\eta\|_2 + 0.262} \quad (9)$$

dans lequel $\|\varepsilon\|_2$ représente une norme 2 d'une matrice de facteur d'écart de courant de fuite $\varepsilon$ du premier transformateur de courant à haute fréquence (9), et dans lequel $\|\eta\|_2$ représente une norme 2 d'une matrice de facteur d'écart de courant de fuite $\eta$ du second transformateur de courant à haute fréquence (11).

3. Procédé selon la revendication 1, dans lequel la détermination d'un état de détérioration d'isolation du câble sur la base du facteur de différence de courant de fuite $\lambda$ du câble comprend spécifiquement les étapes suivantes :

si $\lambda < \theta_1$, la détermination que l'état de détérioration d'isolation du câble de test (16) est dans un très bon état ; si $\theta_1 \leq \lambda < \theta_2$, la détermination que l'état de détérioration d'isolation du câble de test (16) est dans un bon état ; si $\theta_2 \leq \lambda < \theta_3$, la détermination que l'état de détérioration d'isolation du câble de test (16) est dans un état général ; et si $\lambda \geq \theta_3$, la détermination que l'état de détérioration d'isolation du câble de test (16) est dans un état endommagé, dans lequel $\theta_1 = 0{,}281$, $\theta_2 = 5{,}862$ et $\theta_3 = 19{,}218$.

**Fig.1**